(19) Europäisches Patentamt
European Patent Office
Office européen des brevets

(11) **EP 4 679 710 A1**

(12) **EUROPEAN PATENT APPLICATION**

(43) Date of publication:
**14.01.2026 Bulletin 2026/03**

(21) Application number: **24187373.6**

(22) Date of filing: **09.07.2024**

(51) International Patent Classification (IPC):
**H03D 13/00** (2006.01)

(52) Cooperative Patent Classification (CPC):
**H03D 13/007**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **HENSOLDT Sensors GmbH**
**82024 Taufkirchen (DE)**

(72) Inventors:
• **BARAS, Torben**
**89081 Ulm (DE)**
• **DENK, Tanja**
**89171 Illerkirchberg (DE)**

(74) Representative: **LifeTech IP**
**Spies & Behrndt Patentanwälte PartG mbB**
**Elsenheimerstraße 47a**
**80687 München (DE)**

Remarks:
Amended claims in accordance with Rule 137(2) EPC.

(54) **APPARATUS FOR HIGH SENSITIVITY PHASE DETECTION**

(57) Disclosed is an apparatus (100) for high sensitivity phase detection of an electric signal by means of a local oscillator. The apparatus (100) comprises a first mixer unit (110) with a first electric signal connector (111), a first local oscillator connector (112), a first output connector (113), and a first reference connector (114), and the apparatus (100) comprises a second mixer unit (120) with a second electric signal connector (121), a second local oscillator connector (122), a second output connector (123), and a second reference connector (124). The first mixer unit (110) and the second mixer unit (120) are each configured to mix the electric signal with the local oscillator and based thereon produce an output with respect to a potential at the first reference connector (114) or second reference connector (124), respectively. The apparatus comprises a link (140) between the first output connector (113) and the second reference connector (124). The link (140) is configured to provide an input to the second reference connector (124) which is based on an output of the first output connector (113).

Fig. 1

**Description**

The present invention relates to an apparatus and a method for high sensitivity phase detection of an electric signal, a system for controlling a signal of a frequency source, and in particular to a high sensitivity phase detector circuit.

BACKGROUND

A phase detector, or phase comparator, is an electronic device configured to generate a signal which represents the difference in phase between two signal inputs. Detecting phase difference is important in applications in the fields of motor control, radar and telecommunication, servo mechanisms, or demodulation. A phase detector is in particular an essential element of a phase-locked loop, PLL, system, which is a control system configured to generate an output signal at a fixed phase relative to a phase of an input signal.

In the state of the art, analog phase detectors often employ frequency mixers. A mixer is a passive non-linear device that produces multiple output frequencies based on two input signals.

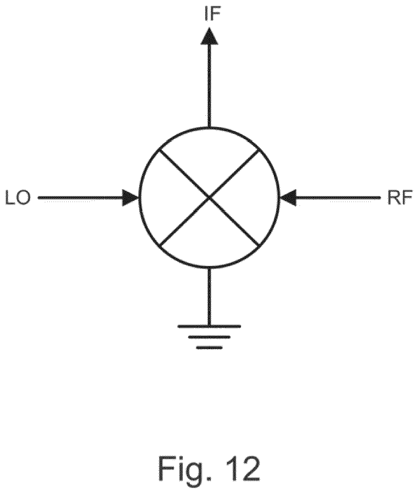

**Fig. 12** shows a schematic representation of such a mixer. The input signals are called LO (local oscillator) and RF (radio frequency), and the output signal is referred to as IF (intermediate frequency). The IF signal comprises the sums and differences of integer multiples of the input frequencies. If LO and RF are equal in frequency, the DC output voltage corresponds to the phase difference between the two input signals and the mixer behaves like a phase detector.

At least in some applications which employ PLL systems, very clean and low-noise signals are required. A particular class comprises low-noise microwave synthesizers for radar applications. In such applications, conventional circuits pose a limitation to obtaining very low noise PLL systems, e.g. due to their intrinsic noise sources.

Phase detectors employed in such PLL systems often include prefabricated mixers, as these standardized electronic devices can be employed in a wide variety of applications.

Available are in particular double-balanced mixers, where both the LO and the RF input signals are applied to differential circuits, so that neither of the input signals and only the product signal appears at the output. Prefabricated double-balanced mixers can reach noise floor levels of about -180 dBc/Hz. However, double-balanced mixers have a rather limited sensitivity due to saturation of the device.

Further available for PLL systems are digital phase detectors, which employ electronic switches in logic gate arrangements. While they can generally reach a higher sensitivity than phase detectors based on double-balanced mixers, and may sometimes also be configured to additionally detect frequency, they show high intrinsic noise levels, which can reach -150d dBc/Hz for current-mode-logic devices and even higher levels of noise, depending on the employed semiconductor materials and circuit designs.

Therefore there is a demand for efficient devices for detecting phase differences with high sensitivity and low noise.

SUMMARY OF THE INVENTION

A contribution to solving the above-mentioned problems is provided by an apparatus for high sensitivity phase detection according to claim 1, a system for controlling a signal of a frequency source according to claim 12, and a method for high sensitivity phase detection of an electric signal according to claim 13. The dependent claims refer to further advantageous realizations for the subject matter of the independent claims.

The present invention relates to an apparatus for high sensitivity phase detection of an electric signal by means of a local oscillator. The apparatus comprises a first mixer unit with a first electric signal connector configured to receive the electric signal, a first local oscillator connector, configured to receive the local oscillator, a first output connector and a first reference connector, and the apparatus further comprises a second mixer unit with a second electric signal connector, configured to receive the electric signal, a second local oscillator connector, configured to receive the local oscillator, a second output connector, and a second reference connector. The first mixer unit and the second mixer unit are each configured to mix the electric signal with the local oscillator and based thereon produce an output at the respective output connector with respect to a potential at the respective first and second reference connector. The apparatus further comprises a link between the first output connector and the second reference connector. The link is configured to provide, as a reference potential for the second mixer unit, an input to the second reference connector which is based on an output of the first output connector.

The link is this configured to establish a connection between the first output connector and the second reference connector such that the reference potential for the second reference connector of the second mixer unit is not an (overall) ground potential (which stays basically constant over time, like signal ground, chassis ground, or earth ground), but is defined by the output of the first mixer unit, and thus varying based on the electric signal and the local oscillator.

The electric signal may be a radio frequency signal, for example an electric AC current or voltage with a signal modulated on a carrier frequency, or a pulsed current or voltage.

The local oscillator (or local oscillator signal) is also a signal, for example an electric AC current or voltage, or a pulsed current or voltage, at or around a local oscillator frequency. Frequencies comprised in the local oscillator typically spread over much narrower band than frequencies of the electric signal.

The apparatus may also be configured, used, or intended for purposes other than phase detection, such as for mixing.

In embodiments where the apparatus is employed or intended for performing a phase detection, the local oscillator may refer to a signal, or to a source of a signal, at a frequency which is precisely or roughly the same as a frequency, or a carrier frequency, of the electric signal. The local oscillator will then generally have a frequency within a frequency band of the electric signal.

In embodiments where the apparatus is employed or intended for performing a mixing, the term "local oscillator" may refer to a signal, or to a source of a signal, at a frequency different from a frequency (or outside of a frequency band) of the electric signal.

The features of the apparatus presented in the following are largely independent of the mode of operation (mixer or phase detector) of the apparatus, and the apparatus will be described for the case of a phase detector for simplicity.

In some embodiments, the apparatus is a device comprising one or more printed circuit boards with circuitry, i.e. traces and/or surface-mounted components, collectively embodying the connectors, connections, and the first and the second mixer unit. One or more further functions may be realized by respective components comprised in or on the one or more printed circuit boards. The apparatus may comprise a final output connection for providing a result of the mixing of the electric signal with the local oscillator.

The term "electric signal connector" may refer to a connection contrivance configured to receive the electric signal, while "local oscillator connector" may refer to a connection contrivance configured to receive the local oscillator (or local oscillator signal). The term "reference connector" may refer to a connection contrivance for connecting the respective mixer unit to a reference or ground potential. The term "output connector" may refer to a connection contrivance for obtaining an output signal of the respective mixer unit.

Components of an electric circuit may be understood to be electrically connected if an electric current can flow between the components through an electric conductor. The apparatus may comprise e.g. traces, tracks or wave guides as signal lines for the electric signal and/or for the local oscillator.

The link between the first output connector and the second reference connector may be a track or trace, or a wave guide, or comprise another contrivance for providing the reference potential for the second mixer unit based on the output of the first mixer unit. The first output connector may be directly electrically connected to the second reference connector such that an electric current can flow from the first output connector to the second reference connector through a direct wire, track, wave guide, or other electric conductor line in or on a printed circuit board.

The apparatus may be configured to receive the electric signal at a single common connector, and to supply the electric signal from there to the first electric signal connector and to the second electric signal connector with equal phase. The apparatus may however also be configured to receive the electric signal at the first electric signal connector and at the second electric signal connector separately, wherein adjusting a respective phase of the electric signal at the first electric signal connector and at the second electric signal connector may have to be ensured outside of the apparatus. Analogous provisions as described here for the electric signal may be realized for the local oscillator.

An effect of the link between the first output connector and the second reference connector is an increased voltage swing in the mixed signal obtained at the second output connector when measured with respect to a potential at the first reference connector.

It is understood that the apparatus may comprise more mixer units than the first mixer unit and the second mixer unit. The apparatus may comprise a plurality of mixer units, and respective links between an output connector of one of the mixer units and a reference connector of another one of the mixer units, such that the plurality of mixer units is connected in a series. Accordingly, first reference connector may be electrically connected to the ground potential, or there may be a further link to a further output connector of a further mixer (and so on). The second output connector may be configured as a (final) output connector of the apparatus, or there may be another link to another reference connector of another mixer (and so on). Multiple mixer units may thus be connected in DC series and RF parallel in order to increase a voltage swing of the apparatus. It is understood that the features described here and in the following for the first mixer unit and for the second mixer unit may likewise be implemented in one or more further mixer units of the apparatus.

Optionally the link comprises filter. The filter may in particular be, or effectively act, as a low-pass filter between the first output connector and the second reference connector, and configured to filter out, i.e. to attenuate or eliminate, components of any signal which have a frequency higher than a threshold frequency, such that only components of frequency lower than the threshold frequency pass from the first output connector to the second reference connector without hindrance. This may be implemented by means of a short-circuit connection to the ground potential for the high frequency components, i.e., by a high-pass filter to the ground potential.

Especially for phase detection, the lower frequency components of the signal may carry the information about a phase difference between the electric signal and the local oscillator, such that an effect of the filter is to adapt the potential at the second reference connector such that it reflects the phase difference.

A further effect of the filter may be to reduce an overall electric impedance which the apparatus, or of the series of mixer units, pose to the electric signal and to the local oscillator. Due to the series connection of the mixer units, an impedance level of the apparatus is generally changed for the RF and LO signals. The filter may thus contribute to adapting the apparatus for small and weak electric signals. In addition, or alternatively, an impedance of one or more conductive tracks providing the electric signal to the first and/or second electric signal connectors may be matched, i.e. adapted, to an impedance of the plurality of mixer units. Likewise, an impedance of one or more conductive tracks providing the local oscillator to the first and/or second local oscillator connectors may be matched, i.e. adapted, to an impedance of the plurality of mixer units.

The filter may be a passive or an active electric or electronic component.

Optionally, the filter between the first output connector and the second reference connector comprises a capacitor. The capacitor may connect a connection line (e.g. trace, track or wave guide) between the first output connector and the second reference connector to the ground potential. The capacitor functions as a short circuit for the high frequency components, and as an open circuit for the low-frequency components, thus represents a high-pass filter to the ground potential.

Alternatively, or additionally, the filter between the first output connector and the second reference connector may comprise a stub. The stub may be a connection line (e.g. trace, track or wave guide) which is connected on one side to the connection line between the first output connector and the second reference connector. The other, free end of the stub may be left open-circuit, or may be short-circuited. An impedance of the stub is then generally purely reactive, and may be capacitive or inductive, depending on the electrical length of the stub and on whether it is open- or short-circuit. The stub may thus be configured to provide an effect similar to that of a capacitor, inductor, or resonant circuit, in particular at radio frequencies.

Alternatively, or additionally, the filter may comprise a resistor. The filter may be an RC low-pass filter, and the resistor may be a part of this low pass filter.

Alternatively, or additionally, the filter may comprise an amplifier, as a particular instance of an active filter. The amplifier may comprise a non-inverting filter circuit.

Optionally, the link comprises one or more antennas. The link may thus be configured to provide the reference potential at the second reference connector based on the output at the first output connector in a wireless way, by electromagnetic radiation.

Alternatively, or additionally, the link may comprise a coupling screen. The coupling screen may be configured to eliminate particular frequencies of radiation passing through the coupling screen. In embodiments, the link may comprise a coupling resonator together with the coupling screen, configured to act as a filter for radiation along the link.

Optionally, the first mixer unit and/or the second mixer unit comprises a ring modulator, configured to provide a mixing by ring modulation. The ring modulator in particular comprises a ring of diodes, facing either all clockwise or all counterclockwise.

Optionally, the apparatus comprises a printed circuit board, and the first mixer unit and/or the second mixer unit comprises a mixer device mounted on a surface of the printed circuit board.

In embodiments, the mixer device may comprise one of the circuits suitable for providing a double balanced mixing as mentioned above. The mixer device may be mounted on the printed circuit board by means of pins. The pins are then accordingly configured to be electrically connected to the electric signal connector, local oscillator connector, output connector and reference connector of the respective mixer unit.

In particular, the mixer device may be a ring modulator.

It can be advantageous to employ prefabricated conventional surface-mounted mixer devices. There exist a large number of such conventional mixer devices, adapted to many frequency ranges and powers. Merely as an example, for electric signals in a frequency band around 6,4 GHz, conventional mixer devices MCA1-80H+ or SIM-762H+ of the company "Mini-Circuits" in Brooklyn, NY, USA were found to be good options.

Conventional mixer devices are typically configured to employ one ground potential for all parts of their circuit. For this, the conventional mixer device may include one or more ground pins, which are intended for being connected to the (fixed) ground potential. However, in embodiments of the apparatus, a mixer device in the second mixer unit (whether conventional or not) has its ground pins connected to the second reference connector, and thus the mixer device is connected to a varying reference potential instead of the ground potential, according to an output of the first mixer unit.

Optionally the mixer device in the first mixer unit or second mixer unit comprises one or more ground pins for connecting the mixer device to a ground potential, and the printed circuit board comprises a single conductive path which electrically connects all of the ground pins to the first reference connector or second reference connector, respectively.

The single conductive path may be configured to connect all ground pins in parallel.

The printed circuit board may comprise more than two layers. The term "layer" shall be understood to include the surfaces of the printed circuit board, i.e., surfaces are understood as particular layers. The single conductive part may comprise parts, i.e., conductive traces, only in one layer, or in more than one layers. In the latter case, the single conductive path may comprise vias, configured to connect parts of the single conductive path on two or more layers. Within one, two, some, or all of the layers of the printed circuit board, the single conductive path may comprise a part which has the form of a loop or polygon.

Besides the ground pins, the mixer device will comprise pins for receiving the electric signal and the harmonic oscillator, and for providing an output.

Optionally the printed circuit board comprises a layer within which the single conductive path comprises a part which encircles all the pins of the mixer device. Encircling may be understood as winding at least once around the pins of the mixer device, such that the pins are located in an interior of an area on the surface of the printed circuit board bounded by the single conductive path. However, where the part of the single conductive path is located on a layer of the printed circuit board which is not the surface of the printed circuit board, it is understood that encircling all pins means encircling all positions on that layer which correspond to positions of the pins on the surface. The single conductive path encircling all pins of the mixer device has an effect of providing a "reference bath" for the mixer device.

Optionally the single conductive path connects one or more of the ground pins via a low-pass filter.

The low-pass filter may again comprise an electric connection to the ground potential, and it may comprise, or be, a capacitor, a resistor, or a coil. The low-pass filter may also comprise stubs. The low-pass filter may also be an active low-pass filter. The low-pass filter has an effect of attenuating high-frequency currents or voltages. In embodiments, the low-pass filter has an effect of providing an effective short circuit to the ground potential for high-frequency currents or voltages. An effect of the low-pass filter is thus to reduce high-frequency noise.

In particular, the single conductive path may have connections to the ground potential (not to be confused with the reference potential) which act as high-pass filters and thus as short circuits for high frequency signals, which may in particular include noise, stray or crosstalk signals at frequencies of the electric signal and/or the local oscillator, while lower frequencies of the actual reference potential are not transmitted by these connections. The single conductive path may be equipped with such connections to the ground potential, or with stubs having a similar effect, on several layers of the printed circuit board.

Optionally the printed circuit board comprises four layers, each of these four layers comprising a part of the single conductive path which encircles all pins of the mixer device, and the part of the single conductive path within a top layer and a part of the single conductive part within a bottom layer are each connected to the ground potential by at least one capacitor for each of the ground pins.

This setup has been found to be remarkably efficient for electric signals and local oscillators at or around 6,4 GHz, over a wide range of numbers of mixer units connected in series as described above.

Optionally the apparatus may be configured to operate in cases where the electric signal comprises a frequency of 6,4 GHz.

Alternatively, or additionally, the apparatus may be configured to operate in cases where the electric signal comprises a frequency in a frequency band used for radar signals. The electric signal may thus have frequencies in older conventional radar bands like the S band (1550 to 3900 MHz), C band (3900 to 6200 MHz), X band (6200 - 10900 MHz), or Ku band (10,9 to 20 GHz), and so on. Or the electric signal may have frequencies in newer conventional radar bands, such as the D band (1 to 2 GHz), E band (2 to 3 GHz), F band (3 to 4 GHz), G band (4 to 6 GHz), H band (6 to 8 GHz), I band (8 to 10 GHz) or J band (10 to 20 GHz), and so on.

Accordingly, the mixer units, components and tracks on the printed circuit board can be appropriately designed for operating the apparatus in these frequencies.

Optionally the apparatus comprises at least one printed circuit board, a plurality of mixer units including the first mixer unit and the second mixer unit, and links configured to connect the plurality of mixer units in a series where every mixer unit has an output connector connected to a reference connector of a next mixer unit and/or a reference connector connected to an output connector of a previous mixer unit, the plurality comprising at least four or eight mixer units.

Embodiments further relate to a system for controlling a signal of a frequency source, comprising the apparatus according to any one of the preceding claims.

The system may in particular be, or comprise, a phase-locked loop. The system may also be a radar system, or a particular device in a radar system.

Embodiments further relate to a method for high sensitivity phase detection of an electric signal by means of a local oscillator. The method comprises mixing, the electric signal with the local oscillator, with respect to a first reference potential, and based thereon producing a first output. The method further comprises mixing the electric signal with the local oscillator with respect to a second reference potential, and based thereon producing a second output. In these steps, the second reference potential is based on the first output. In embodiments, the second reference potential may be immediately given by the first output.

Aspects of advantageous embodiments of the apparatus, the system, and the method can be summarized as follows.

The presented apparatus may be applied for phase detector circuits. These types of electronic components are required to discriminate the phase of a given signal with respect to a reference signal, and provide a low frequency or direct current output signal. The general aim of a phase detector is to provide a high sensitivity in combination with low intrinsic noise.

It is common to use phase-locked-loops, PLL, systems or devices to perform frequency synthesis and stabilization of a signal. In certain types of applications, very clean and low noise signals are required, for example in low noise microwave synthesizers for radar applications. State-of-the-art circuits pose a limitation to very low noise PLL designs due to their intrinsic noise sources.

In embodiments of the apparatus, multiple (N) mixer units, comprising e.g. doubly-balanced mixer devices, are connected in series in such a way that the common ground of a succeeding stage is connected to an intermediate frequency (IF) output port of a respective preceding stage. The connection is provided by a link which can comprise a direct wire or trace, or a wireless (power) connection. This way, the equivalent voltage sources of all mixers are connected in series to achieve N times the voltage swing of the individual phase detector. A first mixer unit in this series may be directly connected to an outer ground potential, while the output of a last mixer unit may serve as an output of the entire apparatus.

Due to the series connection of the mixer units, the impedance level of the circuit (which usually may be e.g. 50 Ohms) is entirely changed for the RF and LO signals. In order to improve the apparatus and the method for small electric signals (and local oscillators), an inner ground node of a mixer device in each mixer unit may be connected to the outer ground potential, e.g. via a capacitor. The capacitor can be seen as a short circuit for higher frequencies, and an open circuit for lower frequencies.

Advantages of the disclosed radar antenna, method and radar system include the following.

The apparatus and the method allow obtaining a very high sensitivity, orders of magnitude higher as compared to examples of phase detectors in the state of the art. Due to the high sensitivity, less amplification is required and the impact of intrinsic noise of subsequent stages is greatly reduced. The apparatus and method thus overcome noise limitations of conventional phase detectors.

By the apparatus and the method, an increased overall sensitivity is achieved due to the interconnection of multiple mixer units, while preserving a low-noise property. Thus, based on the apparatus and the method, very low noise PLL systems can be realized, exceeding the capabilities of conventional PLL devices.

BRIEF DESCRIPTION OF THE DRAWINGS

Various embodiments of the present invention will be described in the following by way of examples only, and with respect to the accompanying drawings, in which:

Fig. 1     shows an apparatus for high sensitivity phase detection according to the present invention.
Fig. 2     illustrates an equivalent circuit diagram for a mixer unit.
Fig. 3     illustrates further aspects of an embodiment of the apparatus.
Fig. 4     illustrates a preferred mixer unit.
Fig. 5     illustrates another preferred mixer unit.
Fig. 6     illustrates another preferred mixer unit.
Fig. 7     shows results of a conversion loss measurement for mixer units.
Fig. 8     shows further details of the results depicted in Fig. 7.
Fig. 9     shows an embodiment of the apparatus with four mixer units.
Fig. 10    illustrates a bandwidth for embodiments of the apparatus.
Fig. 11    shows steps of a method according to the present invention.
Fig. 12    shows a schematic representation of a mixer device.

DETAILED DESCRIPTION

Various examples will now be described more fully with reference to the accompanying drawings in which some examples are illustrated. It should be understood that there is no intent to limit examples to the particular forms disclosed, but on the contrary, examples are to cover all modifications, equivalents, and alternatives falling within the scope of the disclosure as defined by the subsequent claims and the description.

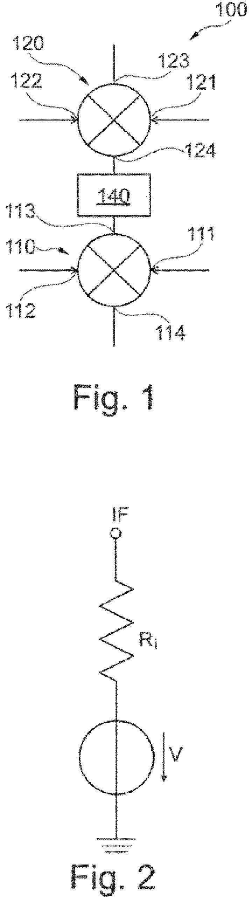

**Fig. 1** shows an apparatus 100 for high sensitivity phase detection of an electric signal by means of a local oscillator. The apparatus 100 comprises a first mixer unit 110 with a first electric signal connector 111, a first local oscillator connector 112, a first output connector 113, and a first reference connector 114. The apparatus 100 further comprises a second mixer unit 120 with a second electric signal connector 121, a second local oscillator connector 122, a second output connector 123, and a second reference connector 124. The first mixer unit 110 and the second mixer unit 120 are each configured to mix the electric signal with the local oscillator, and, based thereon, produce an output with respect to a potential at the first reference connector 114 or the second reference connector 124, respectively. The apparatus further comprises a link 140 between the first output connector 113 and the second reference connector 124. The link 140 is configured to provide, or transmit, an input, which is the reference potential for the second mixer unit 120, to the second reference connector 124 which is based on an output of the first mixer unit 110 at the first output connector 113.

In embodiments, the link comprises a wire (a conductive track, trace, or other conductive line) such that the first output connector 112 is electrically connected to the second reference connector 124 merely by wire. In other embodiments, the link comprises an antenna, such that the first output connector 112 is electrically connected to the second reference connector 124 by a wireless connection.

The first reference connector 114 may be connected to a ground potential, or it may be connected to an output connector of some further mixer unit via a further link. The second output connector may output a resulting signal of the apparatus 100, or it maybe connected to a reference connector of another mixer unit by another link. Thus, in embodiments of the apparatus 100, two or more mixer units are connected in a linear series, with output connectors connected to reference connectors by links as depicted here.

The apparatus 100 can be used for detecting a phase, as well as for mixing the local oscillator and the electric signal. For employing the apparatus 100 as a phase detector, the electric signal may comprise radio frequencies, RF, in some frequency band around a carrier frequency. The local oscillator may be a signal having a frequency at or relatively close to the carrier frequency. For employing the apparatus 100 as a mixer, the local oscillator may be a signal at a frequency which is different from the carrier frequency. In both cases, the electric signal is provided to the first mixer unit 110 and the second mixer unit 120 at the same phase (the phase of the electric signal), or at least at a fixed phase difference. Likewise, the local oscillator is provided to the first mixer unit 110 and the second mixer unit 120 at the same phase (the phase of the local oscillator), or at least at a fixed phase difference.

The apparatus 100 may provide a single common connector for receiving the electric signal, and/or a further single common connector for receiving the local oscillator. In such a case, the apparatus 100 may comprise tracks (not displayed here) configured to provide the electric signal to the first mixer unit 110 and the second mixer unit 120 at the same phase, and/or to provide the local oscillator to the first mixer unit 110 and the second mixer unit 120 at the same phase, respectively.

In further embodiments, the apparatus 100 may provide two (or more) connectors for the electric signal, and/or two (or more) connectors for the local oscillator. In this case, the electric signal (and/or, respectively, the local oscillator) is provided to the two (or more) respective connectors with respective phases, i.e. with a particular fixed phase difference.

Fig. 2 illustrates an equivalent circuit diagram for a mixer unit. Aspects of the DC series connection of the first mixer unit 110 and the second mixer unit 120 shown in Fig. 1 can be understood by considering the equivalent circuit diagram.

The equivalent circuit diagram consists of a voltage source V and an internal resistance $R_i$ in series. An output labeled IF may be understood to represent a voltage at the output connector 113, 123 of one of the first mixer unit 110, the second mixer unit 120, or a further mixer unit. The IF output thus may be understood to depend on a phase difference between the electric signal and the local harmonic oscillator provided to the first or second mixer unit 120, respectively. The resistance corresponds to a fixed attribute of the respective mixer unit. When connecting multiple mixers, such as the first mixer unit 110 and the second mixer unit 120 as in Fig. 1, this corresponds to the IF output of one being connected such that it becomes a reference potential of the next.

Thus, a (full) equivalent circuit diagram for the full series of mixer units in the apparatus 100 comprises a series of voltage sources and resistors according to the equivalent circuit diagram depicted here. A total voltage difference across the full equivalent circuit diagram will be equal to the sum of the voltage offsets generated by each voltage source. Likewise, a resistance of the full equivalent circuit diagram is equal to a sum of the resistances of each individual equivalent circuit diagram (as depicted here) in the full equivalent circuit diagram.

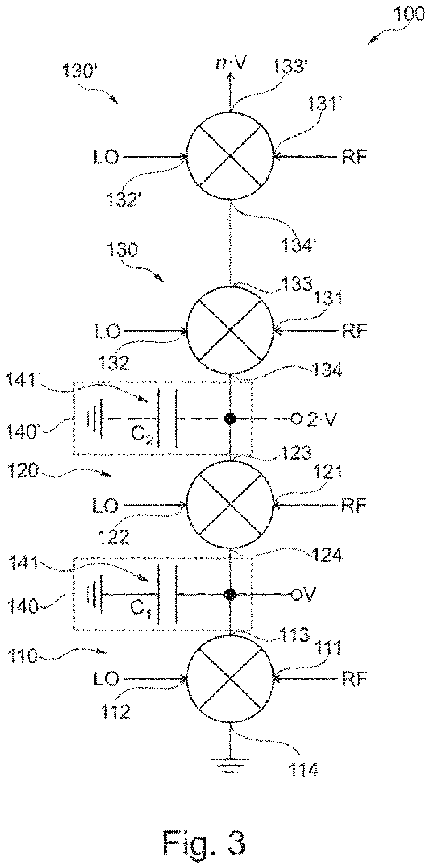

**Fig. 3** illustrates further aspects of an embodiment of the apparatus 100. Here, a number n of mixer units 110, 120, 130, 130', with n equal or greater than two, are connected in a way as illustrated in Fig. 1. In embodiments, n may e.g. be equal to 2, 4, or 8. All mixer units 110, 120, 130, 130' are supplied with the same local oscillator and the same electric signal. The apparatus 100 may be configured with a common connector for the harmonic oscillator and the electric signal, and with tracks configured to split the local oscillator and the electric signal in such a way that they reach the local oscillator connector 112, 122, 132, 132' and the electric signal connector 111, 121, 131, 131' of each mixer unit 110, 120, 130, 130' with respectively equal phase and amplitude.

The first mixer unit 110 is referenced to a ground potential and generates an IF output signal as a voltage with a certain amplitude V. The second mixer unit 120 uses this IF output signal as its reference voltage. Consequently, the voltage across the first mixer unit 110 and the second mixer unit 120 is equal to twice the amplitude of the output of a single mixer, i.e., $2 \cdot V$. Likewise, an output of the second mixer unit 120 serves as reference potential for a third mixer unit 130 (if present), and so on. An output of an nth mixer unit 130' serves as the output of the entire series of mixer units 110, 120, 130, 130'. An output level across all mixer units 110, 120, 130, 130' equals n times the amplitude of a single mixer unit output, i.e., $n \cdot V$. In this way, a high overall output amplitude (or voltage swing) is attained, without adding noise from amplification elements.

However, due to the series connection of the mixer units 110, 120, 130, 130', an impedance level of the circuit as

**EP 4 679 710 A1**

experienced by the local oscillator and the electric signal may be entirely changed compared to an impedance level of a single mixer unit (which may typically be something like 50 Ohm). Embodiments of the apparatus 100 as depicted here may therefore be configured to provide, along each of the connections linking output connectors 113, 123, 133 to respective reference connectors 124, 134, 134', a connection to the common ground potential via links 140, 140' which comprise a high-pass filter to the ground potential. The apparatus 100 in the depicted embodiment is configured with a connection to the ground potential via a capacitor 141, 141' for each link 140, 140' between the mixer units 110, 120, 130, 130'. Each capacitor 141, 141' represents a short circuit for higher frequencies, and an open circuit for lower frequencies. In effect, one link 140 between the first output connector 113 and the second reference connector 124 thus effectively provides a low-pass filter, as only low frequency components can travel from the first mixer unit 110 to the second mixer unit 120 without hindrance. The same applies for each further link 140' in the series of mixer units 110, 120, 130, 130'.

Further embodiments employ further options for the links 140, 140', e.g. other contrivances that constitute an RF short circuit and DC open circuit. Embodiments may in particular include stubs, which may be present instead of or in addition to the capacitors 141, 141'. Embodiments may also comprise antennas, such that the links convey respective reference potential via a wireless connection.

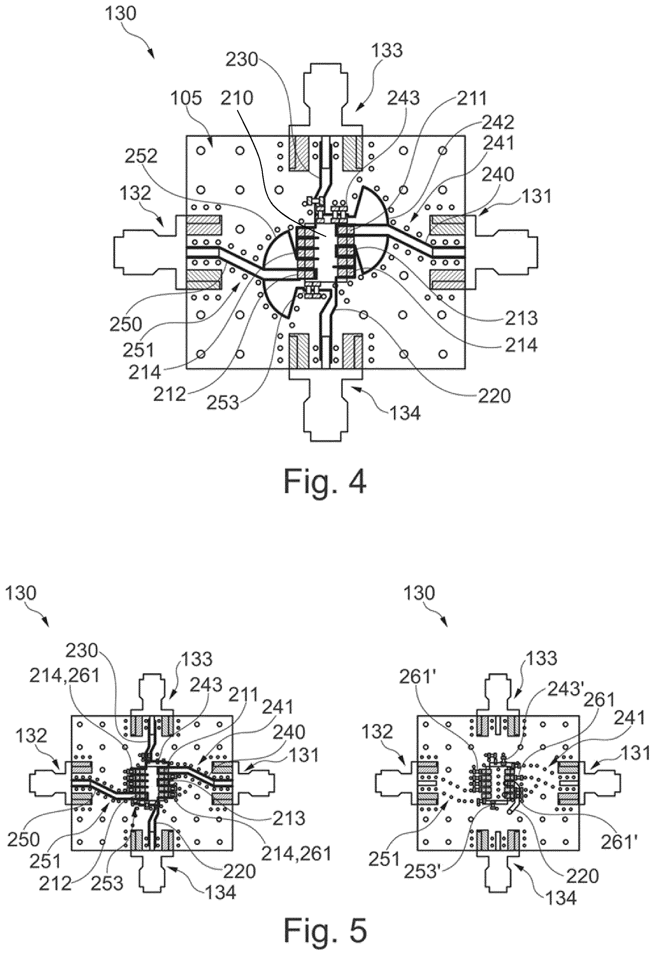

**Fig. 4** illustrates a preferred architecture for a mixer unit 130 in an embodiment of the apparatus 100. This architecture may be the same in every mixer unit 110, 120, 130, 130' in the series. Correspondingly, the mixer unit 130 comprises an electric signal connector 131, a local oscillator connector 132, an output connector 133, and a reference connector 134, and is arranged on a printed circuit board 105, or on a part of a printed circuit board 105. The mixer unit 130 may be understood to comprise the printed circuit board 105, or the part of the printed circuit board 105, or the mixer unit 130 may be understood to comprise only the arrangement of connections and components on the printed circuit board 105 or on the part of the printed circuit board 105 but not the (part of the) printed circuit board 105 itself. In any case, the apparatus 100 comprises the printed circuit board 105 or the part of the printed circuit board 105 occupied by the mixer unit 130.

The mixer unit 130 in the depicted embodiment comprises a mixer device 210 mounted on a surface of the (part of the) printed circuit board 105. The mixer device 210 is a surface mounted device, and may comprise e.g. a ring modulator. The mixer device 210 comprises a number of pins 211, 212, 213, 214 by which it is attached to conductive tracks in and/or on the printed circuit board 105. The pins 211, 212, 213, 214 may consist of one or more first pins 211 for an input of the electric signal, one or more second pins 212 for an input of the local oscillator, one or more third pins 213 for the output of a mixed signal resulting from mixing the electric signal and the local oscillator in the ring modulator, and one or more fourth pins 214 for connecting the ring modulator to a reference potential, which may be provided to the mixer 130 from a mixer 120 prior in the series of mixers 110, 120, 130, 130' via a corresponding link 140'. The reference potential is thus, in general, time-varying. It is based, or may just be equal to, an output of the mixer 120 prior to the mixer 130 depicted here.

In embodiments, the mixer device 210 may be conventional. For example, for electric signals in a frequency band around 6.4 GHz (and a local oscillator at that frequency), conventional mixer devices 210 such as MCA1-80H+ or SIM762H+ by the company called "minicircuits" have been observed to be advantageous.

Conventional surface mounted mixer devices however regularly require the fourth pins, and often an area on the surface of the printed circuit board 105 extending underneath and around the conventional mixer device, to be connected to a (fixed) ground potential. Often conventional mixer devices furthermore require a certain minimum number of vias to connect the area on the surface of the printed circuit board 105 to the ground potential via further layers of the printed circuit board 105. This may depend on a frequency of the electric signal and/or of the local oscillator.

For the presented apparatus 100, such a layout is unsuitable, since only one mixer unit 110 has the ground potential as its reference potential. The other mixer units 120, 130, 130' have a reference potential which, during operation of the apparatus 100, varies, i.e. changes (or may change) over time, given by an output of the respective mixer unit 110, 120, 130 preceding in the series.

The depicted embodiment shows a preferred circuit arrangement for connecting the surface mounted mixer device 210. One advantage of the circuit arrangement is that it relies solely on standard surface mounted components and printed circuit board technology. Other methods of implementation are also possible.

In the depicted embodiment, the mixer unit 130 comprises a single conductive path 220, configured to electrically connect to all ground pins (i.e., all fourth pins 214) of the surface mounted mixer device 210. All ground pins 214 are therefore interconnected. The single conductive path 220 connects the ground pins 214 in parallel.

In the depicted embodiment, the single conductive path 220 may extend only on the surface of the printed circuit board 105. In the depicted embodiment, the single conductive path 220 takes the form of a polygon. However, the single conductive path 220 may comprise parts on other layers, not depicted here, which may be connected to the part on the surface e.g. by vias.

The mixer unit 130 further comprises an electric line 230 connecting the third pins 213 of the mixer device 210 to the output connector 133.

The mixer unit 130 furthermore comprises a first conductive track 240 which is configured to conduct the electric signal from the electric signal connector 131 to the one or more first pins 211 of the surface mounted mixer device 210. The first conductive track 240 may e.g. comprise a microstrip on the surface of the printed circuit board 105, or a suspended strip in a deeper layer of the printed circuit board 105, or a co-planar wave guide.

The mixer unit 130 further comprises first confinement means configured to improve a confinement of the electric signal to the first conductive track 240. Generally, the first confinement means may comprise an electric connection to the ground potential in such a way that the electric signal remains confined to the first conductive track 240. The first confinement means thus improve a guidance of the electric signal along the first conductive track 240.

In the depicted embodiment, the first confinement means comprise first via fences 241, configured around the first conductive track 240 and connecting to the ground potential.

The first confinement means in this embodiment also comprise at least two first stubs 242, arranged on either side around (and roughly radially outward from) the first conductive track 240, and configured as a short circuit for the electric signal. They are designed in such a way that they appear as a short circuit to RF signals at and around a frequency of the electric signal, or a target frequency. The first stubs 242 may be realized as an integral (i.e., electrically connected) part of the single conductive path 220 connecting the reference connector 134 and the ground pins 214, or of the electric line 230 connecting the output connector 133 and the third pins 213. The first stubs 242 are arranged such that they partially enclose a first region around the one or more first pins 211, thereby confining the electric signal to reach only the first pins 211, i.e. to not affect pins 212, 213, 214 of the mixer device which are not the first pins 211.

The first confinement means may comprise a high-pass filter to the ground potential at a position where the first conductive track comes close to either the electric line 230 between the one or more third pins 213 and the output connector 133, and/or close to the single conductive path 220 connecting the fourth pins 214 with the reference connector 134. The high-pass filter to the ground potential may comprise a capacitor 243, configured such that it acts as a short circuit for the electric signal. In the depicted embodiment, the high-pass filter comprises two such capacitors 243, which are positioned on the electric line 230 in close vicinity to the one or more first pins 211.

In advantageous embodiments, the first confinement means (via fences 241, stubs 242, high-pass filters) are positioned as physically close to the first conductive track as possible.

The mixer unit 130 furthermore comprises a second conductive track 250 which is configured to conduct the local oscillator from the local oscillator connector 132 to the one or more second pins 212 of the surface mounted mixer device 210. The second conductive track 250 may e.g. comprise a microstrip on the surface of the printed circuit board 105, or a suspended strip in a deeper layer of the printed circuit board 105, or a co-planar wave guide.

The mixer unit 130 further comprises second confinement means configured to improve a confinement of the local oscillator to the second conductive track 250. Generally, the second confinement means comprise an electric connection to the ground potential in such a way that the local oscillator remains confined to the second conductive track 250. The second confinement means thus improve a guidance of the local oscillator along the second conductive track 250.

In the depicted embodiment, the second confinement means comprise second via fences 251, configured around the second conductive track 250 and connecting to the ground potential.

The second confinement means 250 also comprise at least two second stubs 252, arranged on either side around (and roughly radially outward from) the second conductive track 250, and configured as a short circuit for the local oscillator. The second stubs 252 are arranged such that they partially enclose a second region around the one or more second pins 212, thereby confining the local oscillator to reach only the second pins 212, i.e. to not affect pins 211, 213, 214 of the mixer device which are not the second pins 212.

The second confinement means may comprise a high-pass filter to the ground potential at a position where the second conductive track 250 comes close to either the electric line 230 between the one or more third pins 213 and the output connector 133 and/or to the single conductive path 220 connecting the fourth pins 214 with the reference connector 134. The high-pass filter to the ground potential may comprise a capacitor 253 configured such that it acts as a short circuit for the local oscillator. In the depicted embodiment, the high-pass filter comprises two capacitors 253, which are positioned on the single conductive path 220 in close vicinity to the one or more second pins 212.

In advantageous embodiments, the second confinement means (via fences 251, stubs 252, high-pass filters) are positioned as physically close to the second conductive track 250 as possible.

**Fig. 5** illustrates a preferred architecture for a mixer unit 130 in an embodiment of the apparatus 100. This architecture may be the same in every mixer unit 110, 120, 130, 130' in the series. The architecture depicted here will be mainly described by indicating differences from the architecture depicted in Fig. 4. Consequentially, where features are not explicitly introduced in the following description of Fig. 5, reference is made to the description of the architecture depicted in Fig. 4.

The left-hand side of Fig. 5 depicts a top surface layer of a printed circuit board 105 (or a part of a printed circuit board 105) of the mixer unit 130. The right-hand side of Fig. 5 depicts further advantageous features on a bottom surface layer of the printed circuit board 105 (or the part of the printed circuit board 105). The features depicted on the right-hand side are advantageous but optional; a printed circuit board 105 with a top surface according to the left-hand side of Fig. 5 does not necessarily have to include the features shown for the bottom surface on the right-hand side.

In the following, the left-hand side of Fig. 5 will be described first.

The embodiment again has a preferred circuit arrangement for connecting the surface mounted mixer device 210, which maybe conventional. One advantage of the circuit arrangement is that it relies solely on standard surface mounted components and printed circuit board technology. Other methods of implementation are also possible.

As in Fig. 4, the mixer unit 130 comprises a single conductive path 220. The single conductive path 220 connects all ground pins (fourth pins 214) of the mixer device 210 in parallel and has the form of a polygon. That is, the ground pins 214 of the mixer device 210 are interconnected through a single polygon. However, unlike the embodiment shown in Fig. 4, high-pass filters to the ground potential are placed along the single conductive path 220 at every ground pin 214 of the mixer device 210. These high-pass filters may be implemented e.g. as capacitors 261. The capacitors 261 build an RF bridge between the reference potential of the mixer unit 131 and the ground potential. These high-pass filters have the effect that the single conductive path 220 connects to the ground pins 214 via a low-pass filter.

This use of multiple high-pass filters (capacitors 261) is particularly advantageous in situations where a wavelength of the electric signal and/or the local oscillator is of a same order of magnitude as a characteristic size (like an overall side length) of the single conductive path polygon. The printed circuit board 105 may e.g. comprise a copper plane which extends in a layer of the printed circuit board 105 below the mixer device and is connected to the ground potential. It was observed that an effect of the way in which the high-pass filters are placed here is to prevent a development of self-resonances in the copper plane. For lower frequencies (larger wavelengths) of the local oscillator and/or the electric signal, fewer capacitors can suffice.

The mixer unit 130 comprises a first and a second conductive track 240, 250, which may be similar to the corresponding features in the embodiment shown in Fig. 4. First and second confinement means also include via fences 241, 251, and the embodiment depicted here also comprises two capacitors 243, 253 as high-pass filters connecting the electric line 230 and the single conductive path 220 to the ground potential.

However, in the embodiment depicted here, neither the first nor the second confinement means comprise any stubs.

Turning to the right-hand side of Fig. 5, an arrangement is shown for a bottom surface of the printed circuit board 105.

This arrangement represents an optional extension for the arrangement on the top surface. The single conductive path 220 comprises a polygon on the bottom surface (i.e., comprises a part on the bottom surface which is arranged in a shape of a polygon), wherein a form of the polygon on the bottom surface corresponds to a form of the polygon that the single conductive path 220 describes on the top surface. The polygons on the top and bottom surfaces are connected through vias below the mixer device 210. Similarly as on the top surface, links from the single conductive path 220 to the ground potential via capacitors 261' are also placed on the bottom surface. In the depicted embodiment, such a capacitor 261' is placed at a position opposite to a position of every ground pin 214 on the top surface. The capacitors 261' on the bottom surface are thus configured to provide a better approximation for a layout which is recommended for the conventional mixer device, i.e., an effect of the capacitors 261' is that they simulate a better connection to the ground potential (in other words, a better RF ground connection). Furthermore, links to the ground potential via capacitors 243', 253' are included on the bottom side of the printed circuit board 105.

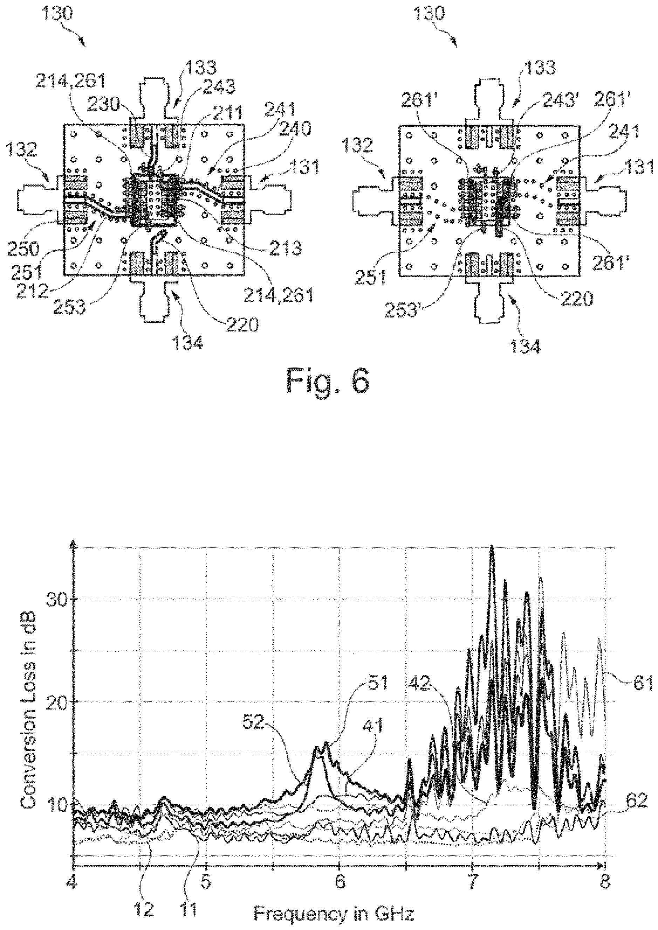

**Fig. 6** illustrates a preferred architecture for a mixer unit 130 in an embodiment of the apparatus 100. This architecture may be the same in every mixer unit 110, 120, 130, 130' in the series. The architecture depicted here will be mainly described by indicating differences from the architectures depicted in Figs. 4 and 5. Consequentially, where features are not explicitly introduced in the following description of Fig. 6, reference is made to the description of any of the architectures depicted in Figs. 4 and 5.

The left-hand side of Fig. 6 depicts a top surface layer of a printed circuit board 105 (or of a part of a printed circuit board 105) of the mixer unit 130. The right-hand side of Fig. 6 depicts further advantageous features on a bottom surface layer of the printed circuit board 105 (or the part of the printed circuit board 105). The features depicted on the right-hand side are advantageous but optional; a printed circuit board 105 with a top surface according to the left-hand side of Fig. 6 does not necessarily have to include the features shown for the bottom surface on the right-hand side.

On the top surface of the printed circuit board 105, the single conductive path 220 comprises a rectangular polygon which runs around the mixer device 210 and encircles in particular all the ground pins 214 of the mixer device 210. In particularly advantageous embodiments, the printed circuit board 105 comprises four layers (including the top surface depicted on the left-hand side and the bottom surface depicted on the right-hand side of Fig. 6), and the single conductive path 220 comprises a polygon of a same or essentially same shape on all four layers. Due to the connection to the reference connector 134, each polygon is at the reference potential that serves as ground for the mixer.

This setup is advantageous for a conventional mixer device 210 for which a recommended layout comprises that the mixer device 210 is engulfed by the reference potential (which is conventionally assumed to not change over time, and is typically the ground potential). By comprising the polygons, the conductive path 220 is configured to imitate this recommended layout.

Similarly as in Figs. 4 and 5, the polygons are also connected to the ground potential via high-pass filters, here by means of capacitors 261, 261', on both the top surface and the bottom surface. It turned out to be advantageous to have one such high-pass filter on both the top surface and the bottom surface for each ground pin 214 of the mixer device 210.

The embodiments depicted in Figs. 4, 5 and 6 may be optimized for and characterized at a frequency of 6.4 GHz, both as a frequency of the local oscillator and as a central frequency of a frequency band of the electric signal. This means in particular that all stubs and capacitances are dimensioned accordingly. For applications at other frequencies, mixer type, stub size, and capacitances may be adjusted.

**Fig. 7** shows results of a conversion loss measurement conducted by means of a network analyzer for mixer units in embodiments as depicted in Figs. 4, 5 and 6 when adapted to a frequency of 6.4 GHz for the local oscillator and within a frequency band of the electric signal, wherein the two conventional mixer devices 210 MCA1-80H+ (in the following referred to as "MCA") and SIM762H+ (in the following referred to as "SIM") mentioned before were employed. A smaller conversion loss is advantageous for a quality, in particular low noise and high accuracy, of the apparatus 100, since more output power is generated at the same input power level.

Parameters for the conversion loss measurement are as follows. The local oscillator ranges from 4 GHz to 8 GHz and has a power output level of 15 dBm. The electric signal has an offset of 100 MHz relative to the local oscillator, and thus spans from 4.1 GHz to 8.1 GHz at a power level of 0 dBm. Consequently, an output frequency of the mixer unit 110, 120, 130, 130' is continuously at 100 MHz, the offset (difference) between the local oscillator frequency and the electric signal frequency.

The conversion loss measurement was performed on four mixer units 130 as depicted in Figs. 4, 5 and 6, and, in addition, on evaluation boards supplied by a manufacturer of the respective conventional mixer device. The evaluation boards are designed according to recommended layouts in corresponding datasheets. A common difference between this design and those of the mixer unit layouts depicted in Figs. 4, 5 and 6 is that the latter provide an effective connection to the ground potential only for high frequencies (in particular comprising characterizing frequencies of the electric signal and/or the local oscillator), while low frequencies (in particular those characterizing the output) are not connected to ground. In contrast, the designs of the evaluation boards provide a connection of the ground pins 214 to the ground potential, indiscriminately for all frequencies.

Fig. 7 shows a diagram of conversion loss results over a range of frequencies from 4 to 8 GHz. The results comprise data curves for the mixer unit 130 depicted in Fig. 4 including stubs with MCA 41 and with SIM 42, data curves for the mixer unit 130 depicted in Fig. 5 on the left-hand side without the features on the right hand side with MCA 51, data curves for the mixer unit 130 depicted in Fig. 5 on the left-hand side together with the features on the right hand side with MCA 52, data curves for the mixer unit 130 depicted in Fig. 6 (including the features on the right-hand side) with MCA 61 and with SIM 62, and data curves for the evaluation boards with MCA 11 and with SIM 12.

From around 4 GHz, all data curves 11, 12, 41, 42, 51, 52, 61, 62 start out with a relatively low conversion loss between 6 and 11 dB. This level is maintained all the way through 6.5 GHz with two exceptions. The MCA data curves 51, 52 for the mixer unit 130 depicted in Fig. 5 spike to 15 dB around a frequency of 5.8 GHz. Beyond 6.5 GHz, the MCA data curves 41, 51, 52, 62 show very large spikes, signifying overall worse performance of the respective mixer units 130 compared performance of mixer units 130 at lower frequencies and compared to performances reflected by SIM data curves 42, 61 in the same frequency range. The SIM conversion loss remains roughly constant for the layout of the mixer unit 130 depicted in Fig. 6, and increases slightly for the layout of the mixer unit 130 depicted in Fig. 4. Naturally, both evaluation boards show the lowest conversion loss nearly throughout the entire frequency range. Their respective data curves 11, 12 are, however, occasionally (i.e., for some frequency ranges) surpassed by both the MCA data curve 61 and the SIM data curve 62 of the layout of the mixer unit 130 of Fig. 6. The MCA evaluation board performance does not decrease beyond 6.5 GHz like the other MCA layouts do. Conversion loss of the mixer units 130 employing SIM is generally lower than conversion loss of the mixer units 130 employing MCA for frequencies above 6.6 GHz.

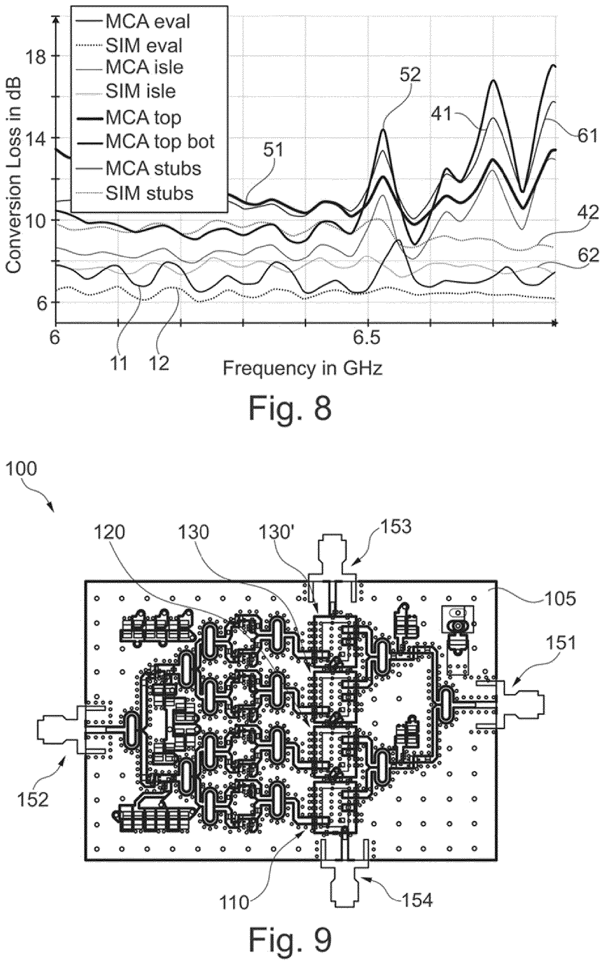

**Fig. 8** shows a section of the diagram of Fig. 7 around a frequency of 6.4 GHz in more detail.

The diagram shows that around this frequency, conversion loss of mixer units 130 employing SIM is continuously lower than conversion loss of mixer units 130 employing MCA.

A surprisingly good performance was achieved for the mixer units 130 with layouts as depicted in Fig. 6. At 6.4 GHz, this layout, with an MCA, has a conversion loss of merely just over 8 dB, while for a SIM, it is just under 8 dB. Their performance is thus close to a performance of the evaluation board layouts, which have conversion loss between 6 dB and 7 dB.

**Fig. 9** shows an embodiment of the apparatus 100 with four mixer units 110, 120, 130, 130' connected in series. Each mixer unit 110, 120, 130, 130' has the layout of the mixer unit 130 depicted in Fig. 6. The apparatus 100 comprises one common electric signal connector 151 configured to receive the electric signal, one common local oscillator connector 152 configured to receive the local oscillator, one main ground connector 154 for connecting the apparatus 100 to the ground potential (which may be signal ground, or chassis ground, earth ground or some other mass, depending on the embodiment) and one main output connector 153 for the resulting signal.

If the embodiment is operated as a phase detector, a voltage swing of the resulting signal is roughly four times a corresponding voltage swing obtained with a single mixer device (of the same kind as used in the mixer units 110, 120, 130, 130' of the present embodiment).

For embodiments of the apparatus 100 with one, two, four, and eight mixer units 110, 120, 130, 130', respectively, all based on the mixer unit layout of Fig. 6 with a conventional MCA mixer device 210, the maximum voltage swing when operated as a phase detector was measured and yielded the results shown in the following table:

| No. of mixer units: | 1 | 2 | 4 | 8 |
|---|---|---|---|---|
| Voltage swing: | 1.05 V | 2.10 V | 4.44 V | 9.13 V |

A single MCA mixer unit has an output voltage range of approximately 1 V. For two MCA mixer units, the swing doubles as expected to just over 2 V. Analogous doublings were observed for four and eight mixer units.

Small variations in the data displayed above can be traced back to non-ideal conditions like component scattering. The source impedance of one mixer unit is roughly equal to 50 $\Omega$. The combined source impedance is proportional to the number of mixers in series; this was measured in the same embodiments and yielded the following results:

| No. of mixer units: | 1 | 2 | 4 | 8 |
|---|---|---|---|---|
| Source impedance: | 61 $\Omega$ | 93 $\Omega$ | 160 $\Omega$ | 400 $\Omega$ |

The combined source impedance was thus roughly proportional to the number of mixer units in series.

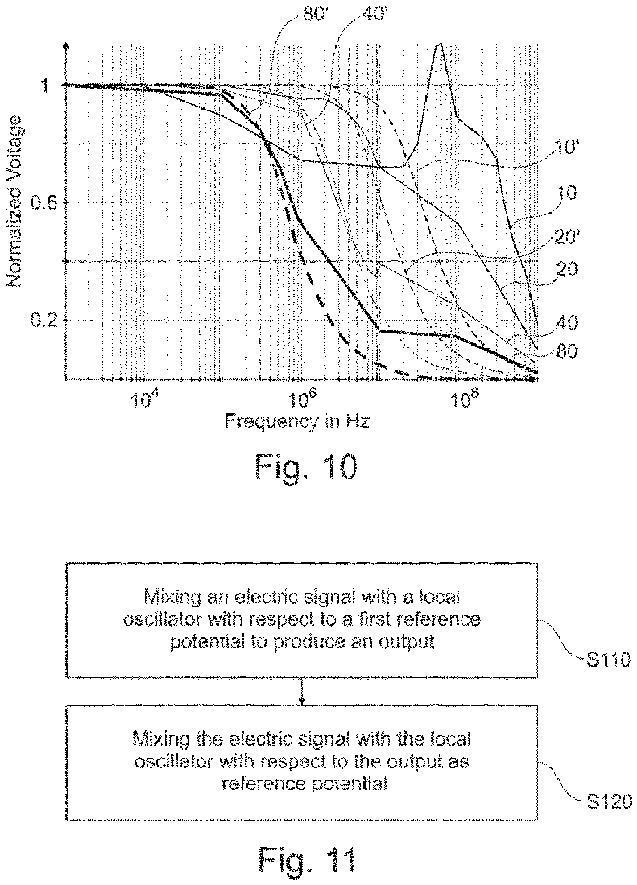

**Fig. 10** shows a diagram illustrating a bandwidth of embodiments of the apparatus 100 similarly as depicted in Fig. 9, but with 2, 4 and 8 mixer units 110, 120, 130, 130', and one arrangement with a single mixer unit 130.

The internal resistances of the mixer devices 210 in combination with capacitances of the mixer units 110, 120, 130, 130' form a low-pass filter. For this embodiment of the apparatus 100, frequency response was both measured on the physical board 105 and simulated using Advanced Design System, ADS, software. The measurement data was acquired by supplying a local oscillator input with 6.4 GHz and an electric signal with a frequency that was 103, 104, ..., 109 Hz higher than that of the local oscillator. The output frequency is equal to the difference between the local oscillator and electric signal frequencies. The bandwidth simulation for comparison was based on a single AC voltage source and an RC low-pass filter. The resistance values were copied from the ones measured and displayed in the second table in the description of Fig. 9 above. The capacitances were equal to $C_{tot}$ = 3.9 pF·27·$n$, where n is the number of mixer units in the apparatus 100. 3.9 pF was the capacitance value of each of the capacitors 243, 253, 261, 261' connecting to the ground potential. Each mixer unit had a total of 27 capacitors 243, 253, 261, 261' on the top and bottom side of the printed circuit board 105. Multiplying these two values by the number of mixer units yields the total capacitance of the layout.

The depicted diagram shows the normalized voltage for each measurement and simulation over the frequency in Hz. This comprises for an apparatus with two mixer units a measured voltage curve 20 and a simulated voltage curve 20'; for an apparatus with four mixer units a measured voltage curve 40 and a simulated voltage curve 40', for an apparatus with eight mixer units a measured voltage curve 80 and a simulated voltage curve 80', and, for comparison, am measured voltage curve 10 and a simulated voltage curve 10' for a single mixer unit. The voltages are normalized to simplify comparison. In actuality, they are approximately multiplied by the number of mixer units in the apparatus 100. For instance, the embodiment of the apparatus 100 with two mixer units had an IF output voltage of just over 2 V at 1 kHz. The simulated voltage curves 10', 20', 40', 80' show that the bandwidth decreases with an increasing number of mixer units, i.e. with increasing values of resistance R and total capacitance $C_{tot}$. This is as expected from a cut-off frequency $f_c$ calculated as

$$f_c = \frac{1}{2\pi R C_{tot}}.$$

The depicted diagram reveals inherent bandwidth limits of the layout of a mixer unit as depicted in Fig. 6 for several mixer units in series.

**Fig. 11** shows steps of a method for high sensitivity phase detection of an electric signal by means of a local oscillator. The method comprises a mixing S110 the electric signal with the local oscillator with respect to a first reference potential, and based thereon produce a first output. The method further comprises mixing S120 the electric signal with the local oscillator and based thereon produce a second output, but with respect to a reference potential basically given by, or is at least based on, the first output.

By mixing S120 the electric signal and the local oscillator with respect to the first output, a signal swing of the second output is higher than a signal swing of the first output.

The description and drawings merely illustrate the principles of the disclosure. It will thus be appreciated that those skilled in the art will be able to devise various arrangements that, although not explicitly described or shown herein, embody the principles of the disclosure as defined by the claims and supported by the description, and are included within its scope.

While each described embodiment may stand on its own as a separate example, it is to be noted that in other embodiments the defined features can be combined differently, i.e. a particular feature described in one embodiment may also be realized in other embodiments. Such combinations are covered by the disclosure herein, unless it is stated that a specific combination is not intended.

Although the invention has been illustrated and described in detail by way of preferred embodiments, the invention is not limited by the examples disclosed, and other variations can be derived from these by the person skilled in the art without leaving the scope of the invention.

List of reference signs

| | |
|---|---|
| 100 | apparatus |
| 105 | printed circuit board |
| 110 | first mixer unit |
| 111 | first electric signal connector |
| 112 | first local oscillator connector |
| 113 | first output connector |
| 114 | first reference connector |
| 120 | second mixer unit |
| 121 | second electric signal connector |
| 122 | second local oscillator connector |
| 123 | second output connector |
| 124 | second reference connector |
| 130 | further mixer unit |
| 131 | electric signal connector |
| 132 | local oscillator connector |
| 132 | output connector |
| 134 | reference connector |
| 140 | link |
| 141 | capacitor |
| 151 | common electric signal |
| 152 | common local oscillator connector |
| 153 | main output connector |
| 154 | main ground connector |
| 210 | mixer device |
| 211, 212, 213, 214 | first, second, third, fourth pins |
| 220 | single conductive path |
| 230 | electric line |
| 240 | first conductive track |
| 241 | via fences |
| 242 | stub |
| 243 | capacitor |
| 250 | second conductive track |
| 251 | via fences |
| 252 | stub |
| 253 | capacitor |
| 261 | capacitor |
| S110, S120 | method steps |

**Claims**

1.    An apparatus (100) for high sensitivity phase detection of an electric signal by means of a local oscillator, the apparatus (100) comprising:

a first mixer unit (110) with a first electric signal connector (111), a first local oscillator connector (112), a first output connector (113), and a first reference connector (114);
a second mixer unit (120) with a second electric signal connector (121), a second local oscillator connector (122), a second output connector (123), and a second reference connector (124); and
a link (140) between the first output connector (113) and the second reference connector (124),
wherein the first mixer unit (110) and the second mixer unit (120) are each configured to mix the electric signal with the local oscillator and based thereon produce an output with respect to a potential at the first reference connector (114) or second reference connector (124), respectively,
and wherein the link (140, 140') is configured to provide an input to the second reference connector (124) based on an output of the first output connector (113).

2. The apparatus (100) according to claim 1, wherein the link (140, 140') comprises a filter.

3. The apparatus (100) according to claim 2, wherein the filter comprises one or more of the following:

   - a capacitor (141, 141'),
   - a stub,
   - a resistor,
   - an amplifier.

4. The apparatus (100) according to any one of the preceding claims, wherein the link (140, 140') comprises one or more of the following:

   - an antenna,
   - a coupling screen.

5. The apparatus (100) according to any one of the preceding claims, wherein the first mixer unit (110) and/or the second mixer unit (120) comprises one of the following:

   - a ring modulator,
   - another double-balanced mixer circuit.

6. The apparatus (100) according to any one of the preceding claims, wherein the apparatus (100) comprises a printed circuit board (105), and the first mixer unit (110) and/or the second mixer unit (120) comprises a mixer device (210) mounted on a surface of the printed circuit board (105).

7. The apparatus (100) according to claim 6, wherein the mixer device (210) comprises one or more ground pins (214) for connecting the mixer device (210) to a ground potential, and wherein the printed circuit board (105) comprises a single conductive path (220) which electrically connects all of the ground pins (214) to the first reference connector (114) or second reference connector (124), respectively.

8. The apparatus (100) according to claim 7, wherein the printed circuit board (105) comprises one or more layers within which the single conductive path (220) comprises a part which encircles all pins of the mixer device.

9. The apparatus (100) according to any one of the claims 7 or 8, wherein the single conductive path (220) connects one or more of the ground pins (214) via a low-pass filter.

10. The apparatus (100) according to any one of the claims 7 to 9, wherein the printed circuit board (105) comprises four layers, each of these four layers comprising a part of the single conductive path (220) which encircles all pins (211, 212, 213, 214) of the mixer device (210), and wherein the part of the single conductive path (220) within a top layer and a part of the single conductive path (220) within a bottom layer are each connected to a ground potential by at least one capacitor (261) for each of the ground pins (214).

11. The apparatus (100) according to any one of the preceding claims, wherein the electric signal comprises a frequency

   - of 6.4 GHz, and/or
   - in a frequency band used for radar signals.

**12.** The apparatus (100) according to any one of the preceding claims, wherein the apparatus (100) comprises a printed circuit board, a plurality of mixer units (110, 120, 130, 130') including the first mixer unit (110) and the second mixer unit (120), and links (140, 140') configured to connect the plurality of mixer units (110, 120, 130, 130') in a series where every mixer unit (110, 120, 130, 130') has an output connector (113, 123, 133) connected to a reference connector (124, 134, 134') of a next mixer unit (120, 130, 130') and/or a reference connector (124, 134, 134') connected to an output connector (113, 123, 133) of a previous mixer unit (110, 120 130), the plurality of mixer units (110, 120, 130, 130') comprising at least four or eight mixer units (110, 120, 130, 130').

**13.** A system for controlling a signal of a frequency source, comprising the apparatus (100) according to any one of the preceding claims, wherein the system is one of the following:

- a phase-locked loop,
- a radar system.

**14.** A method for high sensitivity phase detection of an electric signal by means of a local oscillator, comprising:

mixing (S110), with respect to a first reference potential, the electric signal with the local oscillator and based thereon produce a first output; and
mixing (S120), with respect to a second reference potential, the electric signal with the local oscillator and based thereon produce a second output,
wherein the second reference potential is based on the first output.

**Amended claims in accordance with Rule 137(2) EPC.**

**1.** An apparatus (100) for high sensitivity phase detection of an electric signal by means of a local oscillator signal, the apparatus (100) comprising:

a first mixer unit (110) with a first electric signal connector (111), a first local oscillator signal connector (112), a first output connector (113), and a first reference connector (114); and
a second mixer unit (120) with a second electric signal connector (121), a second local oscillator signal connector (122), a second output connector (123), and a second reference connector (124);
wherein the electric signal is provided to the first mixer unit (110) and the second mixer unit (120) at a same phase or fixed phase difference, and the local oscillator signal is provided to the first mixer unit (110) and the second mixer unit (120) at a same phase or fixed phase difference,
and wherein the first mixer unit (110) and the second mixer unit (120) are each configured to mix the electric signal with the local oscillator signal and based thereon produce an output with respect to a potential at the first reference connector (114) or second reference connector (124), respectively,
**characterized in that**
the apparatus (100) comprises a link (140) between the first output connector (113) and the second reference connector (124), wherein the link (140, 140') is configured to provide, as a reference potential for the second mixer unit (120), an input to the second reference connector (124) based on an output of the first output connector (113).

**2.** The apparatus (100) according to claim 1, wherein the link (140, 140') comprises a filter.

**3.** The apparatus (100) according to claim 2, wherein the filter comprises one or more of the following:

- a capacitor (141, 141'),
- a stub,
- a resistor,
- an amplifier.

**4.** The apparatus (100) according to any one of the preceding claims, wherein the link (140, 140') comprises one or more of the following:

- an antenna,
- a coupling screen.

**5.** The apparatus (100) according to any one of the preceding claims,

wherein the first mixer unit (110) and/or the second mixer unit (120) comprises one of the following:

- a ring modulator,
- another double-balanced mixer circuit.

6. The apparatus (100) according to any one of the preceding claims,
wherein the apparatus (100) comprises a printed circuit board (105), and the first mixer unit (110) and/or the second mixer unit (120) comprises a mixer device (210) mounted on a surface of the printed circuit board (105).

7. The apparatus (100) according to claim 6, wherein the mixer device (210) comprises one or more ground pins (214) for connecting the mixer device (210) to a ground potential, and wherein the printed circuit board (105) comprises a single conductive path (220) which electrically connects all of the ground pins (214) to the first reference connector (114) or second reference connector (124), respectively.

8. The apparatus (100) according to claim 7, wherein the printed circuit board (105) comprises one or more layers within which the single conductive path (220) comprises a part which encircles all pins of the mixer device.

9. The apparatus (100) according to any one of the claims 7 or 8, wherein the single conductive path (220) connects one or more of the ground pins (214) via a low-pass filter.

10. The apparatus (100) according to any one of the claims 7 to 9, wherein the printed circuit board (105) comprises four layers, each of these four layers comprising a part of the single conductive path (220) which encircles all pins (211, 212, 213, 214) of the mixer device (210), and wherein the part of the single conductive path (220) within a top layer and a part of the single conductive path (220) within a bottom layer are each connected to a ground potential by at least one capacitor (261) for each of the ground pins (214).

11. The apparatus (100) according to any one of the preceding claims,
wherein the electric signal comprises a frequency

- of 6.4 GHz, and/or
- in a frequency band used for radar signals.

12. The apparatus (100) according to any one of the preceding claims,
wherein the apparatus (100) comprises a printed circuit board, a plurality of mixer units (110, 120, 130, 130') including the first mixer unit (110) and the second mixer unit (120), and links (140, 140') configured to connect the plurality of mixer units (110, 120, 130, 130') in a series where every mixer unit (110, 120, 130, 130') has an output connector (113, 123, 133) connected to a reference connector (124, 134, 134') of a next mixer unit (120, 130, 130') and/or a reference connector (124, 134, 134') connected to an output connector (113, 123, 133) of a previous mixer unit (110, 120 130), the plurality of mixer units (110, 120, 130, 130') comprising at least four or eight mixer units (110, 120, 130, 130').

13. A system for controlling a signal of a frequency source, comprising the apparatus (100) according to any one of the preceding claims, wherein the system is one of the following:

- a phase-locked loop,
- a radar system.

14. A method for high sensitivity phase detection of an electric signal by means of a local oscillator signal, comprising:

mixing (S110), with respect to a first reference potential, the electric signal with the local oscillator signal and based thereon produce a first output; and
mixing (S120), with respect to a second reference potential, the electric signal with the local oscillator signal and based thereon produce a second output,
wherein the electric signal is provided to the first mixer unit (110) and the second mixer unit (120) at a same phase or fixed phase difference, and the local oscillator signal is provided to the first mixer unit (110) and the second mixer unit (120) at a same phase or fixed phase difference,
**characterized in that**
the second reference potential is based on the first output.

Fig. 1

Fig. 2

Fig. 3

Fig. 4

Fig. 5

Fig. 6

Fig. 8

Fig. 9

Fig. 10

Fig. 11

Fig. 12

## EUROPEAN SEARCH REPORT

**Application Number**

EP 24 18 7373

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2006/105733 A1 (SINGH DONALD R [US] ET AL) 18 May 2006 (2006-05-18) * figure 2 * ----- | 1-14 | INV. H03D13/00 |

| | | | TECHNICAL FIELDS SEARCHED (IPC) |
|---|---|---|---|
| | | | H03D |

The present search report has been drawn up for all claims

| Place of search | Date of completion of the search | Examiner |
|---|---|---|
| Munich | 13 January 2025 | Schnabel, Florian |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 7373

This annex lists the patent family members relating to the patent documents cited in the above-mentioned European search report.
The members are as contained in the European Patent Office EDP file on
The European Patent Office is in no way liable for these particulars which are merely given for the purpose of information.

13-01-2025

| Patent document cited in search report | Publication date | Patent family member(s) | | Publication date |
|---|---|---|---|---|
| US 2006105733 A1 | 18-05-2006 | EP | 1813014 A2 | 01-08-2007 |
| | | US | 2006105733 A1 | 18-05-2006 |
| | | WO | 2007005035 A2 | 11-01-2007 |

EPO FORM P0459

For more details about this annex : see Official Journal of the European Patent Office, No. 12/82